Europäisches Patentamt

European Patent Office

Office européen des brevets

(19)

(11) EP 0 555 092 B1

(12) EUROPEAN PATENT SPECIFICATION

(45) Date of publication and mention
of the grant of the patent:
**14.05.1997 Bulletin 1997/20**

(51) Int Cl.⁶: **H03H 17/06**, H03H 17/02

(21) Application number: **93300868.2**

(22) Date of filing: **05.02.1993**

(54) **Improvements in and relating to digital filters**

Massnahmen zur Verbesserung von digitalen Filtern

Perfectionnements de filtres numériques

(84) Designated Contracting States:
**DE FR GB IT**

(30) Priority: **07.02.1992 GB 9202613**

(43) Date of publication of application:
**11.08.1993 Bulletin 1993/32**

(73) Proprietor: **QUESTECH LIMITED**
**Wokingham Berkshire RG11 2PP (GB)**

(72) Inventor: **Billing, Robert**
**Crowthorne, Berkshire (GB)**

(74) Representative: **Bubb, Antony John Allen et al**
**GEE & CO.**
**Chancery House**
**Chancery Lane**
**London WC2A 1QU (GB)**

(56) References cited:
**EP-A- 0 230 752**        **US-A- 4 953 184**

• **COMPUTER DESIGN vol. 21, no. 4, April 1982,**
**Littleton, Massachusetts, US, pp 159-162; STAN**
**MAZOR: 'APPROACHING FILTERS**
**DISCRETELY'**

## Description

This invention concerns improvements in and relation to digital filters for use in the filtering of digital signals, and more especially to such filters that are arranged to operate on a plurality of samples from a transmitted digital signal in order to suppress components of the signal at particular frequencies. Digital filters of this type are well-known and are described for example in 'Digital and Kalman Filtering' By S.M. Bozic, published by Edward Arnold.

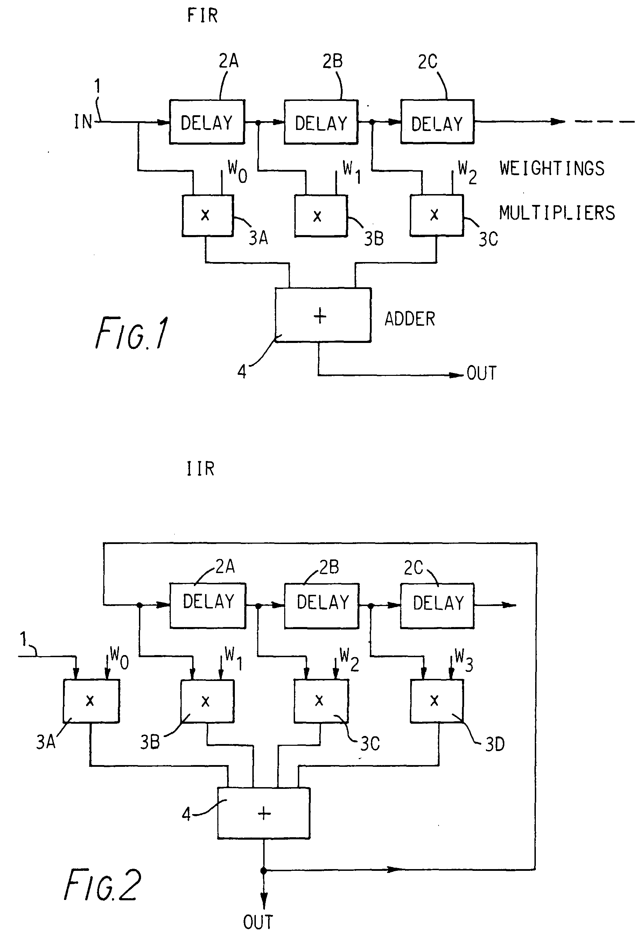

One such known filter is illustrated in Fig. 1 of the accompanying drawings and is known as a Finite Impulse Response filter, hereinafter referred to as an FIR filter. Such a filter is arranged to receive a digital signal at an input 1, to derive a plurality of samples from the input signal via delay lines 2A,2B,2C, etc., to modify the samples by applying weightings in multipliers 3A,3B,3C, etc., and to provide at its output a sum of the weighted signals via an adding circuit 4. The FIR filter as illustrated has the ability to achieve very precise frequency responses, but requires a large amount of hardware, as the number of input samples required to achieve the desired result may be relatively high. In particular, an FIR filter that is required to operate as a low-pass filter with a small cut-off frequency is expensive to implement.

Another form of known filter is illustrated in Fig. 2, and likewise comprises delay means 2A,2B,2C, etc., for providing signal samples, multipliers 3A,3B,3C, etc., for applying weightings to the sample signals, and an adder 4 for providing the output signal. In this case, however, the sample signals provided by the delay means 2A,2B, 2C, etc., are derived not from the signal applied at the input 1, but from the output of the adder 4. A filter having this configuration is referred to as an Infinite Impulse Response filter hereinafter referred to as IIR filter, and has the advantage compared to the FIR filter that it can achieve very low cut-off frequencies with less hardware requirement than the FIR filter, but at the expense of poor control of the overall frequency response.

In the processing of digital video picture images, it is common practice to compress the size of a picture image by effecting corresponding compression of the digital video picture signal to reduce the number of picture points or pixels by means of which the picture is to be displayed. Such compression of a video signal has, however, the objectionable effect of aliasing, in which high frequency information, once compressed, rises to a frequency so high that it exceeds the Nyquist frequency of the sampling system, and appears as low frequency information. It is therefore also common practice to use a digital filter such as an IIR or FIR filter to remove high frequency information from the picture image signal before compression. If an FIR filter is used, then the degree of compression which can be achieved without aliasing depends on the number of samples used by the filter. Thus the greater the degree of compression to be achieved the more expensive the filter becomes. If, on the other hand, an IIR filter is used to reduce expense, some desirable picture information is lost due to the imprecise control of the filter bandwidth.

It is accordingly an object of the present invention to provide a new type of digital filter that can serve to reduce or overcome the above-mentioned disadvantage. Although it is envisaged that such a filter will be particularly useful in the field of image processing, it is anticipated that such a filter would also have advantages in more general use, and thus it is not intended that the invention is to be limited to the field of digital video image processing.

In accordance with one aspect of the invention there is provided a circuit for providing a filtered and compressed digital signal from an input signal, comprising programmable mixing means having two inputs for digital signals, a control input and an output at which is provided a digital signal comprising proportions of signals provided at said two inputs determined by a control signal provided at said control signal input, latch means having an input coupled to the output of said mixing means and having an output coupled to one of the inputs of said mixing means; selecting means coupled to the output of said latch means to enable selection of a predetermined one of a plurality of consecutive signals received from said latch means, and logic means for applying to said programmable mixing means and to said selecting means control signals respectively to cause said mixing means to determine weightings applied respectively to each of a predetermined number of received input signals and to cause the selecting means to select as an output signal a corresponding one of the same predetermined number of signals received from said latch.

It will be seen that the arrangement in accordance with this aspect of the invention is effectively a modified Infinite Impulse Response filter wherein the output signal is derived by cumulative processing of a series of consecutive input signals in order to derive a selected output signal, intermediate output signals being discarded, rather than by simultaneous processing of a plurality of signal samples received from delay lines. By taking advantage of the fact that compression of the signal is to be achieved, the requirement for delay means to provide samples for simultaneous processing can be eliminated. Although this requires intermediate output signals to be discarded, the discarded signals are redundant when signal compression is concerned. Moreover, the logic means can conveniently provide for variable degrees of compression of the input signal by correspondingly selecting the number of consecutive signal samples that are to be processed and the corresponding number of output signals that are to be discarded before the required output signal is obtained.

An arrangement in accordance with this aspect of the invention preferably comprises the second stage of a digital filter of which the first stage is provided by a FIR filter that is arranged to operate upon groups of adjacent samples from an original digital signal and to derive from each group of samples a correspondingly filtered output signal to be provided to the second stage of the filter.

Further preferred features and advantages of the invention will become apparent from the following description.

The invention is illustrated by way of example int he accompanying drawings in which:

Figure 1 is a block circuit diagram of a known form of FIR filter,

Figure 2 is a block circuit diagram of a known form of IIR filter, and

Figure 3 is a block circuit diagram of one embodiment of filter in accordance with the invention.

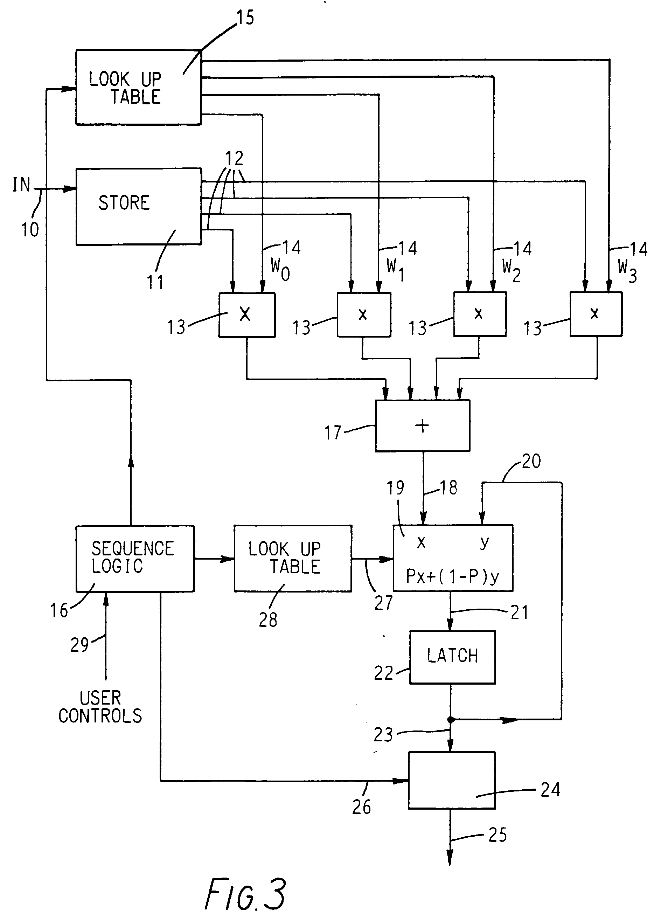

Referring to Fig. 3 of the drawings, there is illustrated a digital filter with particular application to digital video image processing. It will be appreciated that the lines connecting the blocks of the circuit diagram are intended to indicate data paths generally rather than individual electrical connections and that the overall control of the individual functional blocks is effected by timing signals from a clock pulse oscillator not shown, in a manner that will be well known to one skilled in the art. Reference numeral 10 indicates an input via which a digital video signal is to be received and input to a store 11. The store 11 is organised in such a manner that it can store adjacent data samples from a signal provided at the input 10, each sample, for example, providing information relating to a pixel of the video image in the form of an eight bit data word, as is conventional with digital video image processing. The store 11 has a plurality of outputs 12 from which can be read out a plurality of adjacent data samples, e.g. data samples corresponding to adjacent pixels of a picture image. Four outputs 12 are illustrated, but in practice two or any greater number may be used. The outputs 12 are coupled to inputs of corresponding multipliers 13 each of which is arranged to receive a weighting signal on a second input 14. The corresponding weighting signals $W_o$ to $W_3$ are derived from a read only memory 15 controlled from a sequencing logic unit 16, and providing the weightings from a look-up table, the weightings in the look-up table being determined in the conventional manner for an FIR filter.

Output signals from the multipliers 13 are provided to inputs of an adder 17 arranged to provide the sum of the four input signals at an output 18. The output 18 is coupled to one input of a mixer 19, a second input 20 of which is arranged to receive a signal fed back from an output 21 of the mixer 19 via a latch 22. The output of the latch 22 is also coupled to an input 23 of a selector switch or sampling device 24 having an output 25 and a control input 26 coupled to the sequencing logic unit 16.

The mixer 19 also has a control input 27 arranged to receive control signals from a read only memory 28 providing a look-up table, under the control of the sequencing logic unit 16.

The operation of the filter described above is as follows. When image data from the store 11 is to be increased in size, or reduced in size by a small, amount, then the sequencing logic 16 will cause one set of data samples to be read from the store 11 for each sample to be produced at the output 25. The proportion in which signals applied to the mixer 19 are to be mixed will then be set by the sequencing logic 16 and the look-up table 28 so that the sum of products received from the output 18 is written directly to the latch 22 old data from the latch 22 and applied input 20 making no contribution. The filter then functions exactly as a standard FIR filter. If the data is to be reduced in size by more than a factor of two but less than a factor of three, corresponding to a factor of two area reduction in an image, then only half as many output samples need be produced as there are input samples. In this case the sequencing logic 16 will read two sets of samples from the memory 11, form two sums of products at 18 to produce consecutive signal samples and mix them in equal proportions by means of the mixer 19 and the feedback 20 from the latch 22 to produce one output sample which is selected as the second of two consecutive outputs from the latch 22, by means of the selector 24. If the data is to be reduced by a factor of three or more, but less than four then the sequencing logic 16 will read three sets of samples, combining the first two in equal proportions, then taking two thirds of the sum and one third of the third set to produce the final output. In general if the data is to be reduced by a factor of N to N+1 then N sets of samples are used. After each sum of products is formed at the output 18 where S is the sum of products and L is the data in the latch, the sequencing logic will choose a value of proportion P with which to mix the data in the latch and the sum of products such that the new data in the latch is

$$L * ( 1 - P ) + S * P$$

or in other words if P is unity then the sum of products data enters the latch, if P is zero then the data in the latch is preserved. If N sets of samples are to be combined then the values of P for the successive samples are given by the series

$$1 \ 1/2 \ 1/3 \ 1/4 \ ..... \ 1/N$$

which is generated by the sequencing logic.

The effect of this is to produce output samples which, as the degree of size reduction increases, are produced by taking contributions from increasing numbers of input samples. In effect this creates an FIR filter which uses a variable number of samples. Doubling the number of samples used requires double the number of cycles, and hence the rate at which output samples can be produced is halved. This however corresponds to a factor of two reduction in the size of the output signal, typically a factor of two reduction in the area of an image, and hence a factor of two reduction in the number of output samples required.

There is no effective upper limit to the number of sums of products which can be combined in this way, and hence to the effective size of filter which can be produced. In the extreme case one output sample may be produced which is a weighted sum of every sample in the store.

The sequencing logic 16 receives an input control signal 29 which informs it of the exact degree of compression to perform. The source of this control signal is not part of this invention, but is typically some form of operator control panel.

## Claims

1. A filter circuit for providing a filtered and compressed digital signal from an input signal, characterised in that it comprises programmable mixing means (19) having two inputs (18,20) for digital signals, a control input (27) and an output (21) at which is provided a digital signal comprising proportions of signals provided at said two inputs (18,20) determined by a control signal provided at said control signal input (27), latch means 22 having an input coupled to the output (21) of said mixing means (19) and having an output coupled to one of the inputs (20) of said mixing means (19); selecting means (24) coupled to the output of said latch means (22) to enable selection of a predetermined one of a plurality of consecutive signals received from said latch means (22), and logic means (16) for applying to said programmable mixing means (19) and to said selecting means (24) control signals respectively to cause said mixing means (19) to determine weightings applied respectively to each of a predetermined number of received input signals and to cause the selecting means (24) to select as an output signal a corresponding one of the same predetermined number of signals received from said latch means (24).

2. A circuit according to Claim 1 characterised in that said logic means ( 16 ) is adapted to provide for variable degrees of compression of the input signal by correspondingly selecting the number of consecutive signal samples that are to be processed and the corresponding number of output signals that are to be discarded before the required output signal is obtained.

3. A circuit according to Claim 1 or 2, characterised in that it comprises the second stage of a digital filter of which a first stage is provided by a FIR filter (10-15,17) that is arranged to operate upon groups of adjacent samples from an original digital signal and to derive from each group of samples a correspondingly filtered output signal to be provided to the second stage of the filter.

4. A circuit according to Claim 3, characterised in that said FIR filter comprises a memory store (11) organised to store data samples defining adjacent pixels of a digital video image, said store having a plurality of outputs (12) from which can be read a plurality of data samples corresponding to adjacent pixels of a stored picture image; a plurality of multipliers (13) each of which has a first input coupled to a corresponding output of the memory store (11) and a second input (14) arranged to receive a weighting signal from a control means (15) defining the response of the FIR filter; and an adder (17) having inputs coupled to respective outputs of said multiplier (13), for providing an output signal that is the sum of the signals provided.

5. A circuit according to any one of Claims 1-4, characterised in that said logic means (16) is coupled to said programmable mixing means (19) via a read-only memory (28) providing a look-up table determining the weightings applied by said mixing means (19).

6. A circuit according to Claim 5, characterised in that said logic means (16) comprises a sequencing unit having a control input (29) for receiving a signal defining a degree of compression to be applied by the filter circuit and having an output arranged to apply to said read only memory (28) a sequence of signals providing from said look-up table a correspondingly required sequence of signals determining the weighting to be applied by said mixing means (19).

7. A circuit according to Claim 6, characterised in that the arrangement is such that for compression of incoming data signals received by said mixing means (19) by a factor of N to N+1, the said sequencing unit (16) is arranged to cause said selector (24) to select the Nth signal of each group of N consecutive output signals from said latching means (22), and is arranged to cause the mixing means (19) to weight signals received at said one input (20) by a factor 1-P and to weight signals received at the other input (18) by a factor P, where for the sequence of N incoming signals the sequencing unit (16) causes the value of P to follow the sequence $1, 1/2, 1/3, 1/4, ----- 1/N$.

8. A circuit as claimed in any one of Claims 5-7 as appended to Claim 4, characterised in that said logic means (16) is coupled to each of said multipliers (13) by means of a read only memory (15) providing a look-up table of weightings to be applied via the weighting signals to said second inputs (14) of the multipliers.

9. A circuit as claimed in Claim 8, when appended to Claim 6, characterised in that said sequencing unit (16) is arranged to cause, for a given sequence of sets of data samples to be read from said video image memory (11), coordinated sets of weighting signals to be read from said read only memories (15 and 28).

## Patentansprüche

1. Filterschaltung zum Bereitstellen eines gefilterten und komprimierten digitalen Signals aus einem Eingangssignal, dadurch gekennzeichnet, daß sie versehen ist mit einer programmierbaren Mischeranordnung (19), die zwei Eingänge (18, 20) für digitale Signale, einen Steuereingang (27) und einen Ausgang (21) aufweist, an dem ein digitales Signal bereitgestellt wird, das Anteile von an den beiden Eingängen (18, 20) anliegenden Signalen aufweist, die von einem dem Steuersignaleingang (27) zugeführten Steuersignal bestimmt sind; ferner mit einer Zwischenspeicheranordnung (22), die einen mit dem Ausgang (21) der Mischeranordnung (19) gekoppelten Eingang und einen mit einem der Eingänge (20) der Mischeranordnung (19) gekoppelten Ausgang aufweist; des weiteren mit einer mit dem Ausgang der Zwischenspeicheranordnung (22) gekoppelten Wählanordnung (24), die eine Auswahl eines vorbestimmten aus einer Mehrzahl von aufeinanderfolgenden Signalen erlaubt, die von der Zwischenspeicheranordnung (22) empfangen werden; sowie mit einer Logikanordnung (16) um an die programmierbare Mischeranordnung (19) und die Wählanordnung (24) Steuersignale anzulegen, um die Mischeranordnung (19) zu veranlassen, Bewertungen für jedes einer vorbestimmten Anzahl von empfangenen Eingangssignalen zu bestimmen, und um die Wählanordnung (24) zu veranlassen, ein entsprechendes der von der Zwischenspeicheranordnung (22) empfangenen gleichen vorbestimmten Anzahl von Signalen als ein Ausgangssignal auszuwählen.

2. Schaltung nach Anspruch 1, dadurch gekennzeichnet, daß die Logikanordnung (16) zum Bereitstellen variabler Kompressionsgrade für das Eingangssignal geeignet ist, indem die Anzahl der zu verarbeitenden aufeinanderfolgenden Signalabtastwerte und die entsprechende Anzahl von Ausgangssignalen, die unberücksichtigt zu bleiben haben, bevor das erforderliche Ausgangssignal erhalten wird, entsprechend ausgewählt werden.

3. Schaltung nach Anspruch 1 oder 2, dadurch gekennzeichnet, daß sie die zweite Stufe eines digitalen Filters bildet, dessen erste Stufe von einem Filter (10-15, 17) mit endlicher Impulsantwort gebildet ist, das so ausgelegt ist, daß es auf Gruppen von benachbarten Abtastwerten aus einem ursprünglichen digitalen Signal einwirkt und aus jeder Gruppe von Abtastwerten ein entsprechend gefiltertes Ausgangssignal ableitet, das der zweiten Stufe des Filters zugeht.

4. Schaltung nach Anspruch 3, dadurch gekennzeichnet, daß das Filter mit endlicher Impulsantwort versehen ist mit einem Speicher (11), der so ausgelegt ist, daß er Datenabtastwerte speichert, die benachbarte Piksel eines digitalen Videobildes bestimmen, wobei der Speicher eine Mehrzahl von Ausgängen (12) aufweist, von denen eine Mehrzahl von Datenabtastwerten entsprechend benachbarten Pikseln eines gespeicherten Bildes ausgelesen werden kann; ferner mit einer Mehrzahl von Multiplizierstufen (13), von denen jede einen mit einem entsprechenden Ausgang des Speichers (11) gekoppelten ersten Eingang und einen zweiten Eingang (14) aufweist, der ein Bewertungssignal von einer Steueranordnung (15) aufnimmt, welche das Ansprechverhalten des Filters mit endlicher Impulsantwort bestimmt; sowie mit einer Addierstufe (17), die mit entsprechenden Ausgängen der Multiplizierstufen (13) gekoppelte Eingänge aufweist, um ein Ausgangssignal bereitzustellen, das die Summe der angelieferten Signale ist.

5. Schaltung nach einem der Ansprüche 1 bis 4, dadurch gekennzeichnet, daß die Logikanordnung (16) mit der programmierbaren Mischeranordnung (19) über einen Nur-Lese-Speicher (28) gekoppelt ist, der eine Nachschlagtabelle bereitstellt, welche die Bewertungen bestimmt, die von der Mischeranordnung (19) bereitgestellt werden.

6. Schaltung nach Anspruch 5, dadurch gekennzeichnet, daß die Logikanordnung (16) eine Folgesteuerungseinheit mit einem Steuereingang (29) zur Aufnahme eines Signals, das einen von der Filterschaltung anzuwendenden Kompressionsgrad bestimmt, und mit einem Ausgang aufweist, der so ausgelegt ist, daß dem Nur-Lese-Speicher (28) eine Folge von Signalen zugeführt wird, die bewirken, daß von der Nachschlagtabelle eine entsprechend benötigte Folge von Signalen bereitgestellt wird, welche die von der Mischeranordnung (19) anzuwendende Bewertung bestimmen.

7. Schaltung nach Anspruch 6, dadurch gekennzeichnet, daß die Anordnung so getroffen ist, daß zum Komprimieren von einlaufenden Datensignalen, die von der Mischeranordnung (19) empfangen werden, um einen Faktor von N bis N+1 die Folgesteuerungseinheit (16) so ausgelegt ist, daß die Wählanordnung (4) veranlaßt wird, das N-te Signal jeder Gruppe von N aufeinanderfolgenden Ausgangssignalen von der Zwischenspeicheranordnung (22) auszuwählen, und so ausgelegt ist, daß die Mischeranordnung (19) veranlaßt wird, an dem einen Eingang (20) empfangene Signale mit einem Faktor 1-P zu bewerten, und an dem anderen Eingang (18) empfangene Signale mit einem Faktor P zu bewerten, wobei die Folgesteuerungseinheit (16) für die Folge von N einlaufenden Signalen bewirkt, daß der Wert von P der Folge 1, 1/2, 1/3, 1/4, ... 1/N entspricht.

8. Schaltung nach einem der Ansprüche 5 bis 7, soweit sich diese auf Anspruch 4 beziehen, dadurch gekennzeichnet, daß die Logikanordnung (16) mit jeder der Multiplizierstufen (13) über einen Nur-Lese-Speicher (15) gekoppelt ist, der eine Nachschlagtabelle für Bewertungen bereitstellt, die über die Bewertungssignale den zweiten Eingängen (14) der Multiplizierstufen zuzuführen sind.

9. Schaltung nach Anspruch 8, soweit sich dieser auf Anspruch 6 bezieht, dadurch gekennzeichnet, daß die Folgesteuerungseinheit (16) so ausgelegt ist, daß sie bewirkt, daß für eine vorgegebene Folge von Gruppen von Datenabtastwerten, die aus dem Videobildspeicher (11) auszulesen sind, koordinierte Gruppen von Bewertungssignalen von den Nur-Lese-Spcichern (15 und 28) ausgelesen werden.

**Revendications**

1. Circuit de filtrage pour la fourniture d'un signal numérique filtré et comprimé à partir d'un signal d'entrée, caractérisé par le fait qu'il comprend un moyen de mélange programmable (19) ayant deux entrées (18, 20) pour des signaux numériques, une entrée de commande (27) et une sortie (21) à laquelle est fourni un signal numérique comprenant des proportions de signaux fournis aux deux entrées (18, 20) déterminées par un signal de commande fourni à l'entrée de signal de commande (27), un moyen de verrouillage (22) ayant une entrée reliée à la sortie (21) du moyen de mélange (19) et une sortie reliée à une des entrées (20) du moyen de mélange (19), un moyen de sélection (24) relié à la sortie du moyen de verrouillage (22) pour permettre la sélection d'un signal déterminé d'une série de signaux consécutifs reçus du moyen de verrouillage (22), et un moyen logique (16) pour l'application au moyen de mélange programmable (19) et au moyen de sélection (24) de signaux de commande respectivement pour faire déterminer au moyen de mélange (19) des pondérations appliquées respectivement à chaque signal d'un nombre déterminé de signaux d'entrée reçus et faire sélectionner au moyen de sélection (24) comme signal de sortie l'un correspondant du même nombre déterminé de signaux reçus du moyen de verrouillage (24).

2. Circuit selon la revendication 1, caractérisé par le fait que le moyen logique (16) est conçu pour pourvoir à des degrés variables de compression du signal d'entrée en sélectionnant de manière correspondante le nombre d'échantillons de signaux consécutifs qui doivent être traités et le nombre correspondant de signaux de sortie qui doivent être rejetés avant que le signal de sortie requis soit obtenu.

3. Circuit selon l'une des revendications 1 et 2, caractérisé par le fait qu'il comprend le deuxième étage d'un filtre numérique dont un premier étage est fourni par un filtre RIF (10 à 15, 17) qui est conçu pour opérer sur des groupes d'échantillons voisins à partir d'un signal numérique original et tirer de chaque groupe d'échantillons un signal de sortie filtré de manière correspondante à fournir au deuxième étage du filtre.

4. Circuit selon la revendication 3, caractérisé par le fait que le filtre RIF comprend une mémoire (11) organisée pour emmagasiner des échantillons de données définissant des pixels voisins d'une image vidéo numérique, cette mémoire ayant une série de sorties (12) par lesquelles peuvent être extraits une série d'échantillons de données correspondant à des pixels voisins d'une image mémorisée ; une série de multiplieurs (13) qui ont chacun une première entrée reliée à une sortie correspondante de la mémoire (11) et une deuxième entrée (14) conçue pour recevoir un signal de pondération d'un moyen de commande (15) déterminant la réponse du filtre RIF ; et un additionneur (17) ayant des entrées reliées à des sorties respectives du multiplieur (13), pour fournir un signal de sortie qui est la somme des signaux fournis.

5. Circuit selon l'une des revendications 1 à 4, caractérisé par le fait que le moyen logique (16) est relié au moyen de mélange programmable (19) par l'intermédiaire d'une mémoire morte (28) fournissant une table à consulter qui détermine les pondérations appliquées au moyen de mélange (19).

6. Circuit selon la revendication 5, caractérisé par le fait que le moyen logique (16) comprend un organe de séquencement ayant une entrée de commande (29) pour la réception d'un signal déterminant un degré de compression à appliquer au circuit de filtrage et une sortie conçue pour appliquer à la mémoire morte (28) une suite de signaux fournissant depuis la table à consulter une suite requise de manière correspondante de signaux déterminant la pondération à appliquer au moyen de mélange (19).

7.  Circuit selon la revendication 6, caractérisé par le fait que le montage est tel que pour la compression de signaux de données entrants reçus par le moyen de mélange (19) par un facteur compris en N et N+1, l'organe de séquencement (16) est agencé pour faire sélectionneur au sélecteur (24) le Nième signal de chaque groupe de N signaux de sortie consécutifs du moyen de verrouillage (22), et agencé pour faire pondérer au moyen de mélange (19) des signaux reçus à la première entrée (20) par un facteur 1-P et pondérer des signaux reçus à l'autre entrée (18) par un facteur P, l'organe de séquencement (16), pour la suite de N signaux entrants, faisant suivre à la valeur de P la suite 1, 1/2, 1/3, 1/4, ...., 1/N.

8.  Circuit selon l'une des revendications 5 à 7 jointe à la revendication 4, caractérisé par le fait que le moyen logique (16) est reliée à chacun des multiplieurs (13) au moyen d'une mémoire morte (15) fournissant une table à consulter de pondérations à appliquer par l'intermédiaire des signaux de pondération aux deuxièmes entrées (14) des multiplieurs.

9.  Circuit selon la revendication 8, lorsqu'elle est jointe à la revendication 6, caractérisé par le fait que l'organe de séquencement (16) est conçu pour produire, pour une suite donnée de groupes d'échantillons de données à extraire de la mémoire d'images vidéo (11), l'extraction de groupes coordonnés de signaux de pondération des mémoires mortes (15 et 28).

FIR

*FIG.1*

IIR

*FIG.2*

FIG.3